# EUROPÄISCHE PATENTSCHRIFT

(11) **EP 0 945 984 B1**
(45) Veröffentlichungstag und Bekanntmachung des Hinweises auf die Patenterteilung: **14.06.2006**
(21) Anmeldenummer: 99106043.5
(22) Anmeldetag: 25.03.1999
(51) Int. Cl.: H03K 17/96

(54) **Verfahren zum Betreiben eines kapazitiven Schalters und Schaltungsanordnung eines kapazitiven Schalters**
Method for operating a capacitive switch and capacitive switch circuit
Procédé d'opération d'un commutateur capacitif et circuit de commutation capacitif

(30) Priorität: 25.03.1998 DE 19813013
(43) Veröffentlichungstag der Anmeldung: 29.09.1999
(73) Patentinhaber: i f m electronic gmbh, D-45127 Essen (DE)
(72) Erfinder: Palata, Jaromir, 88046 Friedrichshafen (DE); Schulz, Jörg, 6890 Lustenau (AT)
(74) Vertreter: Gesthuysen, von Rohr & Eggert

(56) Entgegenhaltungen:
- EP-A- 0 438 158
- EP-A- 0 792 020
- FR-A- 2 331 211
- US-A- 5 573 012

## Beschreibung

Die Erfindung betrifft ein Verfahren zum Betreiben eines kapazitiven Schalters, wobei der Schalter einen ein Meßsignal liefernden Oszillator, einen aus zumindest einer Sendeelektrode und einer Meßelektrode bestehenden kapazitiven Sensor und eine Auswerteschaltung aufweist. Darüber hinaus betrifft die Erfindung eine Schaltungsanordnung eines kapazitiven Schalters, mit einem Oszillator, mit einer Meßstrecke und mit einer Auswerteschaltung, wobei der Oszillator ein Meßsignal liefert und die Meßstrecke zumindest einen Sensor mit einer Sendeelektrode und einer Meßelektrode aufweist.

Ein derartiger kaparitiver Schalter ist beispielsweise in der DE 2549588 A1 beschrieben.

Schalter, insbesondere induktive und kapazitive Schalter, werden in einer Vielzahl von ganz unterschiedlichen Anwendungsgebieten in der industriellen Technik eingesetzt. Dabei kann es sich sowohl um berührungslos arbeitende Schalter handeln, d. h. um solche Schalter, bei denen sich das Betätigungsobjekt lediglich der aktiven Fläche des Schalters nähert, die dann meist als Näherungsschalter bezeichnet werden, als auch um berührend arbeitende Schalter handeln, d. h. um solche Schalter, bei denen das Betätigungsobjekt eine aktive Fläche des Schalters berührt. Gemeinsam ist diesen Schaltern, daß es sich um sogenannte offene elektronische Systeme handelt, d. h. die aktiven Sensoren nicht gänzlich abgeschirmt sind und somit elektromagnetische Strahlen und Signale in ihre Umwelt abgeben und umgekehrt elektromagnetische Strahlen und Signale aus der Umwelt aufnehmen. Dieser Umstand kann einerseits zu Störabstrahlungen des Schalters, andererseits auch zu Störeinstrahlungen in den Schalter führen.

Das zuvor erläuterte Problem versucht man bei Schaltern dadurch in den Griff zu bekommen, daß einerseits die aktiven Sensoren zumindest teilweise abgeschirmt werden, daß andererseits die an den Sensoren anliegende Spannung verringert wird. Beides führt jedoch automatisch zu einem geringeren maximal möglichen Objekterfassungsabstand - allgemein als Schaltabstand bezeichnet - und/oder zu einem schlechteren Verhältnis von Nutzsignal zu Störsignal.

Durch die zunehmende Verbreitung von elektromagnetische Strahlen und Signale aussendenden Geräten, wie beispielsweise Mobiltelefone oder Fernbedienungen, und durch die verstärkte Anwendung von Schaltern auch in der Nähe solcher elektromagnetische Signale aussendender Geräte kann es verstärkt zu Fehlfunktionen der Schalter und/oder der elektronischen Geräte durch Störab- und Störeinstrahlungen kommen. Als Beispiel sei hier die Verwendung von kapazitiven Schaltern in Türgriffen von Kraftfahrzeugen genannt, die einerseits durch die abgestrahlten Signale eines Autotelefons gestört werden, andererseits selber das Autotelefon stören können.

Die EP 0 438 158 B1 beschreibt ein Verfahren zum Betreiben eines kaparitiven Flüssigkeitspegelsensors, bei dem durch wiederholtes Variieren der Frequenz des mit dem Sensor gekoppelten Oscillators, Interferenzen durch externe Radiosender verringert werden und von dem Sensor ausgehende Strahlung verringert wird.

Der vorliegenden Erfindung liegt somit die Aufgabe zugrunde, ein Verfahren zum Betreiben eines Schalters bzw. eine Schaltungsanordnung eines Schalters zur Verfügung zu stellen, bei dem bzw. bei der die Störabstrahlung bzw. die Empfindlichkeit gegenüber Störeinstrahlungen verringert ist.

Die zuvor hergeleitete und aufgezeigte Aufgabe ist nach einer ersten Lehre der Erfindung bei dem eingangs beschriebenen Verfahren dadurch gelöst, daß das Meßsignal durch ein von einer Rauschquelle geliefertes Rauschsignal frequenzgespreizt wird, daß das frequenzgespreizte Meßsignal einerseits - vorzugsweise über ein Anpassungsnetzwerk - auf den ersten Eingang eines Korrelators gegeben und andererseits von der Sendeelektrode des kapazitiven, Sensors abgestrahlt wird, daß das von der Meßelektrode des Sensors aufgenommene Empfangssignal auf den zweiten Eingang des Korrelators gegeben wird und daß das Ausgangssignal des Korrelators der Auswerteschaltung zugeführt wird. Nach einer zweiten Lehre der Erfindung wird die zuvor hergeleitete und aufgezeigte Aufgabe bei dem eingangs beschriebenen Verfahren dadurch gelöst, daß ein zweiter Oszillator ein Hilfssignal erzeugt, welches die gleiche oder eine geringfügig andere Frequenz als das Meßsignal hat, daß das Meßsignal und das Hilfssignal durch ein von einer Rauschquelle geliefertes Rauschsignal frequenzgespreizt werden, daß das frequenzgespreizte Meßsignal von der Sendeelektrode des kapazitiven Sensors abgestrahlt wird, daß das frequenzgespreizte Hilfssignal - vorzugsweise über ein Anpassungsnetzwerk - auf den ersten Eingang eines Korrelators gegeben wird, daß das von der Meßelektrode des Sensors aufgenommene Empfangssignal auf den zweiten Eingang des Korrelators gegeben wird und daß das Ausgangssignal des Korrelators der Auswerteschaltung zugeführt wird.

Durch die - mittels eines Rauschsignals erfolgende - Frequenzspreizung des Meßsignals sowohl gemäß der ersten als auch gemäß der zweiten Lehre der Erfindung wird die Bandbreite vergrößert und damit die spektrale Energiedichte des Meßsignals verringert, ohne die an dem Sensor anliegende Spannung verringern zu müssen. Dadurch wird einerseits die Amplitude der ausgesendeten Störsignale reduziert, wird andererseits die maximal zulässige Amplitude eines in den Schalter eingestrahlten Störsignals erhöht. Somit wird sowohl die Störung anderer Geräte durch den Schalter als auch die Empfindlichkeit des Schalters gegenüber Störungen durch andere Geräte verringert.

Wesentlich für die Lehre der Erfindung ist also, daß das Meßsignal nicht monofrequent oder schmalbandig vorliegt, vielmehr sich innerhalb eines - breitbandigen - Frequenzspektrums befindet.

Nach einer ersten vorteilhaften Ausgestaltung sowohl der ersten als auch der zweiten Lehre der Erfindung wird die Frequenzspreizung des Meßsignals bzw. des Hilfssignals durch eine Frequenzmodulation des Meßsignals bzw. des Hilfssignals mit dem Rauschsignal erzeugt. Vorteilhafterweise wird dabei zur Frequenzmodulation ein Transistor verwendet, der gleichzeitig als Rauschverstärker dient. Bei einem solchen Verfahren ist besonders vorteilhaft, daß nur sehr wenige Bauteile gebraucht werden und insgesamt nur ein sehr geringer Stromverbrauch auftritt. Ein solches Verfahren eignet sich besonders bei unkritischen Sensorapplikationen, d. h. bei solchen Sensoren, die keinen großen Schaltabstand brauchen. Ein mögliche Anwendung eines solchen Verfahrens ist die Anwendung bei einem kapazitiven Autotürgriff, bei der es wichtig ist, daß der Schalter nur sehr wenig Strom verbraucht, damit bei einer längeren Standzeit des Autos die Batterie nicht entladen wird.

Nach einer alternativen vorteilhaften Ausgestaltung des Verfahrens gemäß der ersten oder der zweiten Lehre der Erfindung wird die Frequenzspreizung des Meßsignals bzw. des Hilfssignals durch eine Phasenumtastung des Meßsignals bzw. des Hilfssignals erzeugt. Bei einer Phasenumtastung, die vorteilhafterweise mit Hilfe eines aus dem Rauschsignal erhaltenen binären Zufallssignals durch eine 0/180°-Phasenumtastung erfolgt, ist eine sehr hohe Störfestigkeit realisierbar. Bei einem solchen Verfahren ist auch dann eine Korrelation möglich, wenn eine ständige elektrische Verbindung zwischen dem Sender und dem Empfänger nicht möglich oder nicht erwünscht ist. In einem solchen Fall müßte der Korrelationscode dann gespeichert und übertragen werden.

Im Rahmen der Erfindung kann auch auf ein Meßsignal als solches verzichtet werden, also das Rauschsignal als Meßsignal verwendet werden. Dann ist es natürlich nicht möglich, mit Hilfe des zweiten Korrelators aus dem breitbandigen Empfangssignal ein solches zu generieren, das monofrequent oder schmalbandig ist.

Die der Erfindung zugrundeliegende Aufgabe ist bei der eingangs genannten Schaltungsanordnung eines Schalters dadurch gelöst, daß eine Rauschquelle und zwei Korrelatoren vorhanden sind, daß in dem ersten Korrelator eine Frequenzspreitzung des Meßsignals durch die Rauschquelle erfolgt, daß das frequenzgespreizte Meßsignal einerseits mit dem ersten Eingang des zweiten Korrelators und andererseits mit der Sendeelektrode verbunden ist und daß die Meßelektrode mit dem zweiten Eingang des zweiten Korrelators verbunden ist. Mit einer solchen Schaltungsanordnung ist das Verfahren gemäß der ersten Lehre der Erfindung besonders vorteilhaft anwendbar. Die Schaltungsanordnung ist dadurch besonders einfach und stromsparend ausgebildet, daß als Rauschquelle die Emitterdiode eines Transistors im Durchbruchbetrieb benutzt wird. Im Sinne einer nur wenige Bauteile benötigenden Schaltungsanordnung ist es vorteilhaft, wenn als erster Korrelator ein zweiter Transistor vorhanden ist, der sowohl als Rauschverstärker dient als auch die Frequenzmodulation des Meßsignals mit dem Rauschsignal realisiert.

Unter einem Korrelator im Sinne dieser Patentanmeldung ist eine elektronische Baugruppe zu verstehen, mit der die Mittelwertbildung von Produkten (Korrelation) realisiert wird. Dabei besteht das Produkt aus der multiplikativen Verknüpfung von mehreren Eingangssignalen, die analogen oder binären Charakter besitzen können. Die Mittelwertbildung erfolgt durch Integration mehrerer zeitlich aufeinanderfolgender Multiplikationsvorgänge entweder mit Zeitquantisierung oder durch fortlaufende Integration ohne Zeitquantisierung. Je nach der Art der Eingangssignale und der Mittelwertbildung werden verschiedene Typen von Korrelatoren unterschieden. Bei einem Multiplikationskorrelator werden zwei analoge elektrische Eingangssignale ohne Zeit- oder Amplitudenquantisierung miteinander verarbeitet. In einem Relaiskorrelator werden ein analoges und ein binäres elektrisches Eingangssignal miteinander verarbeitet. Ein solcher Relaiskorrelator kann beispielsweise ein Ringmischer sein. Unter einen Polaritätskorrelator wird ein Korrelator verstanden, der zwei oder mehr binäre elektrische Signale miteinander verarbeitet. Ein solcher Polaritätskorrelator kann beispielsweise ein Inverter sein, insbesondere ein EX-OR-Gatter oder ein FlipFlop.

Eine Schaltungsanordnung, die besonders zur Durchführung des Verfahrens gemäß der zweiten Lehre der Erfindung geeignet ist, ist dadurch gekennzeichnet, daß ein zweiter, ein Hilfssignal erzeugender Oszillator vorhanden ist und zwei Inverter vorhanden sind, daß jeweils ein Eingang der beiden Inverter mit der Rauschquelle und der andere Eingang mit dem Meßsignal bzw. mit dem Hilfssignal verbunden ist und daß der Ausgang des ersten Inverters mit der Sendeelektrode und der Ausgang des zweiten Inverters mit dem ersten Eingang des zweiten Korrelators verbunden ist.

Als Oszillator eignet sich besonders ein Rechteckoszillator, der sehr einfach mit einem Quarz und einem HCMOS-Gatter realisiert werden kann. Auch ein Keramikoszillator kann verwendet werden. Diese Oszillatortypen sind sehr preiswert und darüber hinaus auch ausreichend temperatur- und frequenzstabil.

Im einzelnen gibt es nun eine Vielzahl von Möglichkeiten, die erfindungsgemäßen Verfahren bzw. die erfindungsgemäße Schaltungsanordnung auszugestalten und weiterzubilden. Dazu wird verwiesen sowohl auf die den Patentansprüchen 1, 2 und 10 nachgeordneten Patentansprüche als auch auf die Beschreibung der in der Zeichnung dargestellten bevorzugten Ausführungsbeispiele erfindungsgemäßer Schaltungsanordnungen. In der Zeichnung zeigen
- Fig. 1: eine Diagrammdarstellung eines ersten Ausführungsbeispiels einer erfindungsgemäßen Schaltungsanordnung,
- Fig. 2: zwei Diagrammdarstellungen von zwei Ausführungsbeispielen der erfindungsgemäßen Schaltungsanordnung,
- Fig. 3: eine Diagrammdarstellung eines besonders einfachen Ausführungsbeispiels einer erfindungsgemäßen Schaltungsanordnung,
- Fig. 4: eine Diagrammdarstellung einer erfindungsgemäßen Schaltungsanordnung ähnlich der Schaltungsanordnung gemäß Fig. 1,
- Fig. 5: eine Diagrammdarstellung einer erfindungsgemäßen Schaltungsanordnung ähnlich der Schaltungsanordnung gemäß Fig. 2a,
- Fig. 6: bevorzugte Ausführungsbeispiele eines Teils einer erfindungsgemäßen Schaltungsanordnung,
- Fig. 7: ein weiteres bevorzugtes Ausführungsbeispiel eines Teils einer erfindungsgemäßen Schaltungsanordnung und
- Fig. 8: nochmals bevorzugte Ausführungsbeispiele eines Teils einer erfindungsgemäßen Schaltungsanordnung.

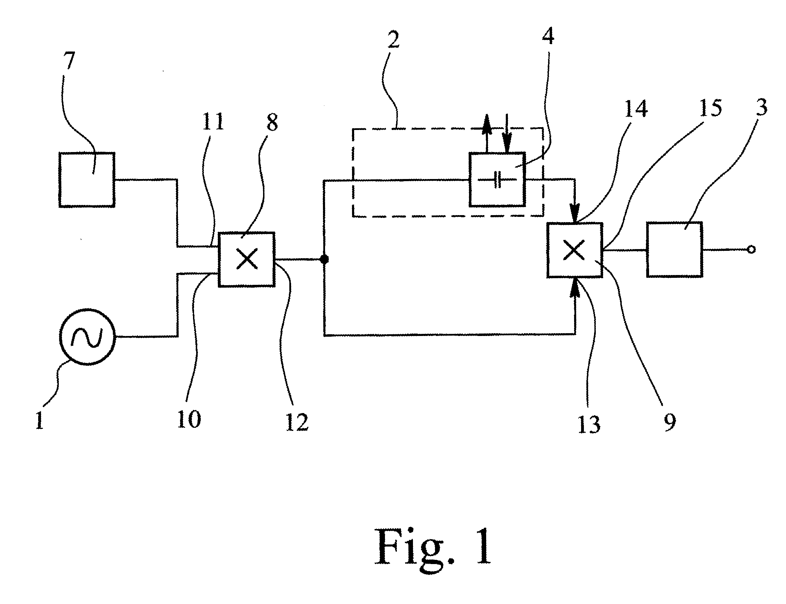

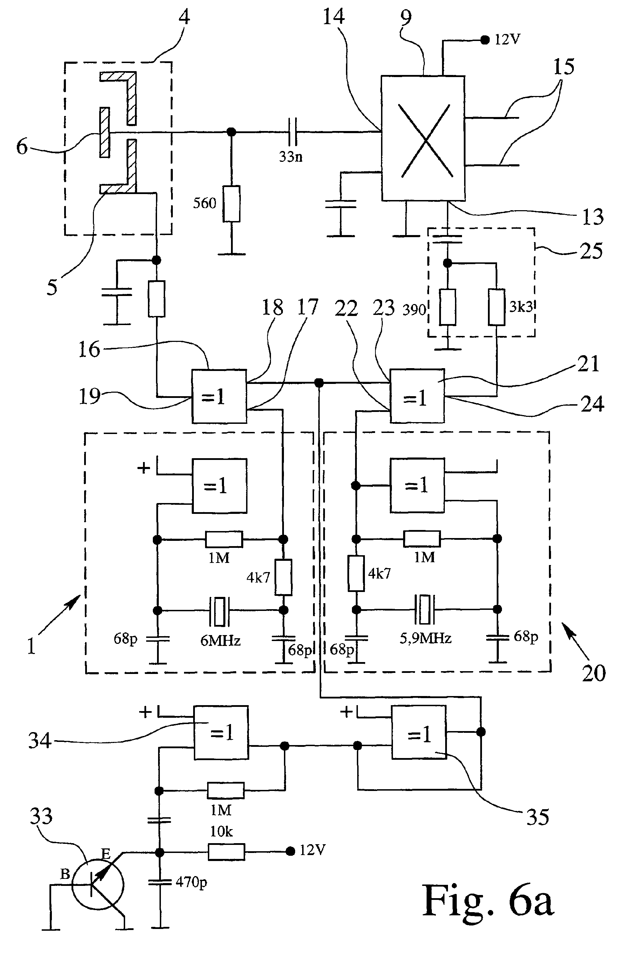

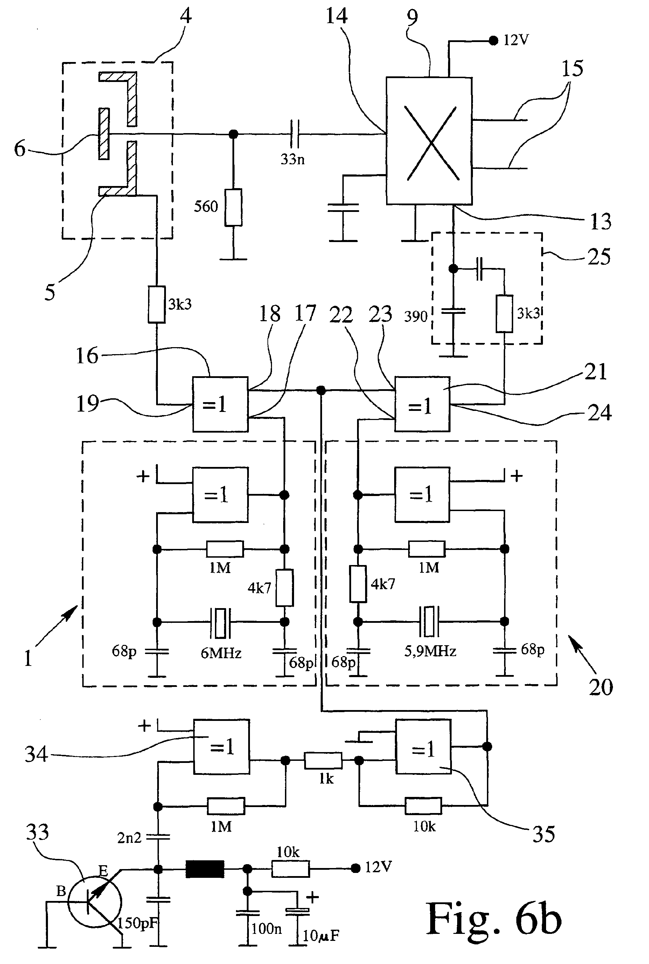

Die Fig. 1 bis 3 zeigen unterschiedliche Ausführungsbeispiele erfindungsgemäßer Schaltungsanordnungen eines Schalters, die alle zunächst einen Oszillator 1, eine Meßstrecke 2 und eine Auswerteschaltung 3 aufweisen. Die Meßstrecke 2 enthält einen Sensor 4, der hier stets als kapazitiver Sensor angedeutet ist. Der Sensor 4 strahlt elektromagnetische Signale in seine Umwelt ab und nimmt umgekehrt elektromagnetische Signale aus der Umwelt auf, was durch die eingezeichneten Pfeile dargestellt ist, und besteht aus einer Sendeelektrode 5 und einer Meßelektrode 6, wie dies in Fig. 6 dargestellt ist, kann darüber hinaus jedoch auch noch beispielsweise eine Masseelektrode aufweisen.

Die Schaltung gemäß Fig. 1 weist erfindungsgemäß eine Rauschquelle 7 und zwei Korrelatoren 8 und 9 auf. Der Oszillator 1 ist mit dem ersten Eingang 10 und die Rauschquelle 7 mit dem zweiten Eingang 11 des Korrelators 8 verbunden. In dem ersten Korrelator 8 erfolgt eine Frequenzspreizung des von dem Oszillator 1 abgegebenen Meßsignals. Der Ausgang 12 des Korrelators 8 ist sowohl mit dem Sensor 4 als auch mit dem ersten Eingang 13 des zweiten Korrelators 9 verbunden. Der zweite Eingang 14 des zweiten Korrelators 9 ist mit der Meßelektrode 6 des Sensors 4 verbunden. Das frequenzgespreizte Meßsignal wird somit einerseits auf die Sendeelektrode 5, andererseits direkt auf den zweiten Korrelator 9 gegeben. Am Ausgang 15 des zweiten Korrelators 9 erhält man ein ungespreiztes Empfangssignal, welches zur weiteren Verarbeitung der Auswerteschaltung 3 zugeführt wird.

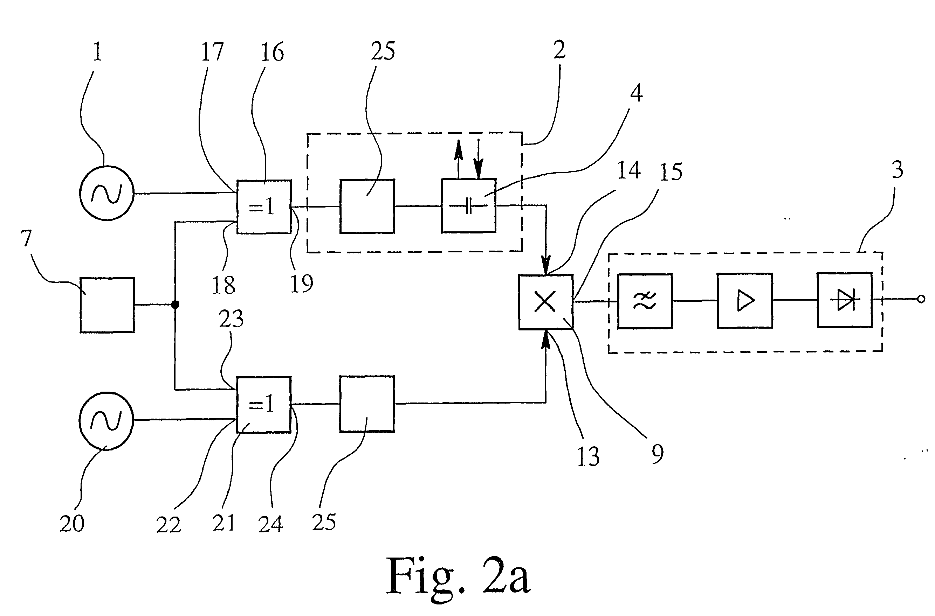

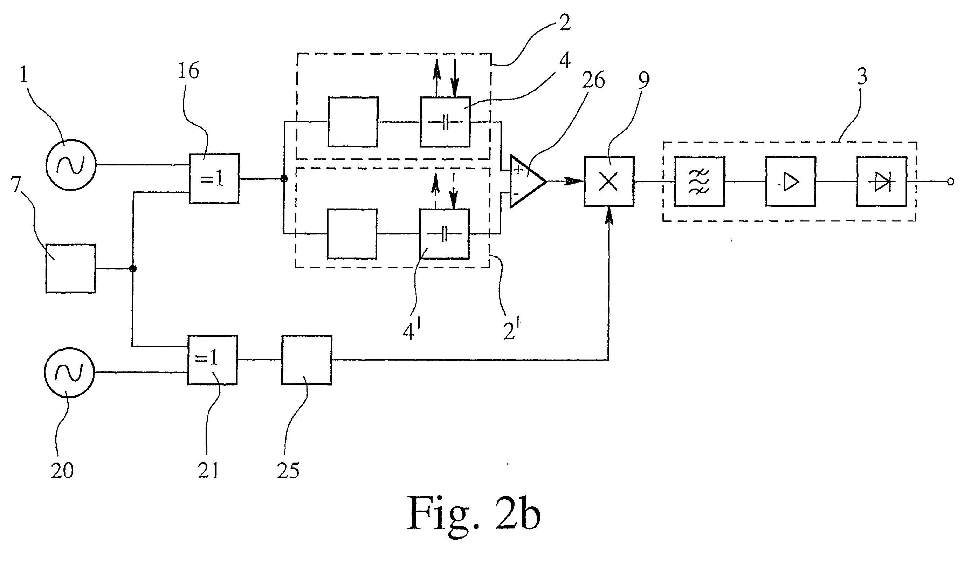

Im Unterschied zur Schaltungsanordnung nach Fig. 1 ist bei den Schaltungsanordnungen nach den Fig. 2, 4 und 5 der erste Korrelator jeweils als Inverter 16 ausgebildet. Von dem Inverter 16 ist der erste Eingang 17 mit dem Oszillator 1 und der zweite Eingang 18 mit der Rauschquelle 7 verbunden. Im übrigen weist die Schaltungsanordnung gemäß den Fig. 2a und 2b einen zweiten Oszillator 20 auf, welcher ein Hilfssignal erzeugt. Das Hilfssignal kann entweder dieselbe Frequenz wie das Meßsignal haben oder vorteilhafterweise eine geringfügig von dem Meßsignal verschiedene Frequenz aufweisen. Durch einen zweiten Inverter 21 wird das Hilfssignal des Oszillator 20 durch das Rauschsignal genauso frequenzgespreizt wie durch den Inverter 16 das Meßsignal frequenzgespreizt wird. Dazu ist der Oszillator 20 mit dem ersten Eingang 22 des zweiten Inverters 21 und die Rauschquelle 7 mit dem zweiten Eingang 23 des Inverters 21 verbunden. Selbstverständlich kann an Stelle des zweiten Inverters 21 auch ein anderer geeigneter Korrelator verwendet werden.

Das frequenzgespreizte Hilfssignal wird vom Ausgang 24 des Inverters 21 über ein Anpassungsnetzwerk 25 auf den ersten Eingang 13 des zweiten Korrelators 9 gegeben, während das frequenzgespreizte Meßsignal vom Ausgang 19 des Inverters 16 auf die Sendeelektrode 5 des Sensors 4 und das von der Meßelektrode 6 des Sensors 4 empfangene Empfangssignal auf den zweiten Eingang 14 des Korrelators 9 gegeben wird. Am Ausgang 15 des zweiten Korrelators 9 liegt somit ein unkorreliertes Empfangssignal mit einer der Frequenzdifferenz von Meßsignal zu Hilfssignal entsprechenden Zwischenfrequenz an.

Die Meßstrecke 2 enthält neben dem Sensor 4 noch ein Anpassungsnetzwerk 25, wobei es sich bei dem Anpassungsnetzwerken 25 in der Regel um eine passive elektrische Baugruppe handelt, bestehend aus Widerständen und Kondensatoren. Durch die beiden Anpassungsnetzwerke 25 wird eine Frequenzgang- und Laufzeitanpassung der beiden an dem zweiten Korrelator 9 ankommenden Signale realisiert.

Die Schaltungsanordnung nach Fig. 2b unterscheidet sich von der nach Fig. 2a dadurch, daß der Meßstrecke 2 eine zweite, im wesentlichen identische Meßstrecke 2' parallel geschaltet ist. Die zweite Meßstrecke 2' kann dabei entweder einen zweiten aktiven Sensor 4' enthalten oder lediglich als Referenzmeßkanal, beispielsweise zur Kompensation einer Temperaturdrift, eingesetzt werden. Die Meßstrecken 2 und 2' werden auf einen Differenzmeßverstärker 26 gegeben, dessen Ausgang mit dem Eingang 14 des zweiten Korrelators 9 verbunden ist.

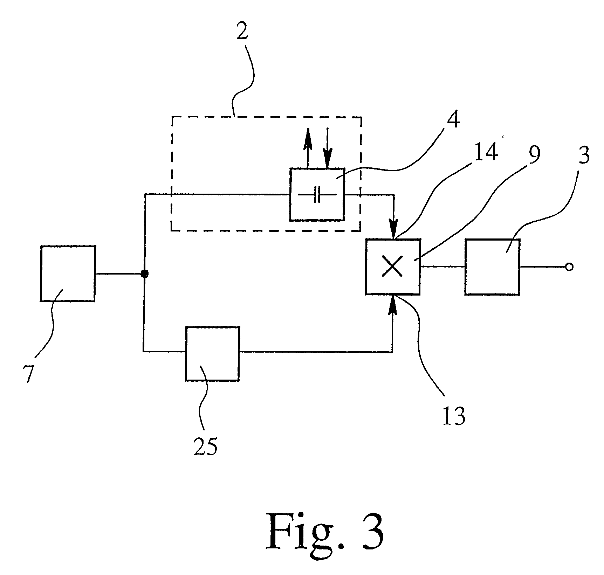

Fig. 3 zeigt eine Alternative einer Schaltungsanordnung mit sehr wenigen Bauteilen, bei der als Meßsignal direkt das Rauschsignal einer Rauschquelle 7 verwendet wird, so daß ein separater Oszillator entfällt. Das Rauschsignal wird einerseits über die aus dem Sensor 4 bestehende Meßstrecke 2 geführt, andererseits über ein Anpassungsnetzwerk 25 auf den ersten Eingang 13 des zweiten Korrelators 9 gegeben. Eine solche Schaltungsanordnung hat zwar auch den Vorteil eines sehr breiten Frequenzspektrums, jedoch ist in der Regel für das Betreiben eines Sensors ein schmalbandiges Meßsignal erforderlich, weswegen in der Regel mindestens ein Oszillator verwendet wird, wie dies in den übrigen Figuren dargestellt ist.

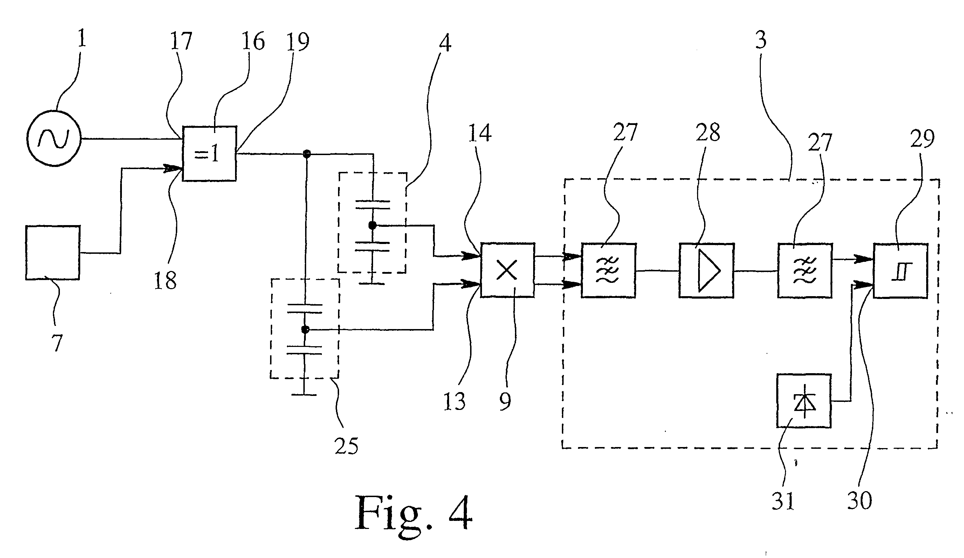

Fig. 4 zeigt eine Schaltungsanordnung, die der Schaltungsanordnung aus Fig. 1 im wesentlichen entspricht. Der erste Korrelator ist wiederum als Inverter 16 ausgeführt, und das Anpassungsnetzwerk 25 entspricht im wesentlichen dem Sensor 4, so daß das Anpassungsnetzwerk 25 die Funktion eines Referenzmeßkanals übernimmt. Im Unterschied zum Sensor 4 ist das Anpassungsnetzwerk 25 jedoch nicht nach außen aktiv, d. h. es wird nicht durch ein Betätigungsobjekt beeinflußt. Bei dem zweiten Korrelator 9 handelt es sich vorteilhafterweise um einen 4-Quadranten-Multiplizierer oder einen Multiplexer, an dessen Ausgang ein Gleichspannungssignal anliegt, welches zunächst ein Filter 27 durchläuft, dem sich ein Verstärker 28 und ein zweites Filter 27 anschließt. Abschließend wird das Signal auf einen Spannungskomparator 29 mit Hysterese gegeben, an dessen zweiten Eingang 30 eine eine Referenzspannung liefernde Zenerdiode 31 angeschlossen ist.

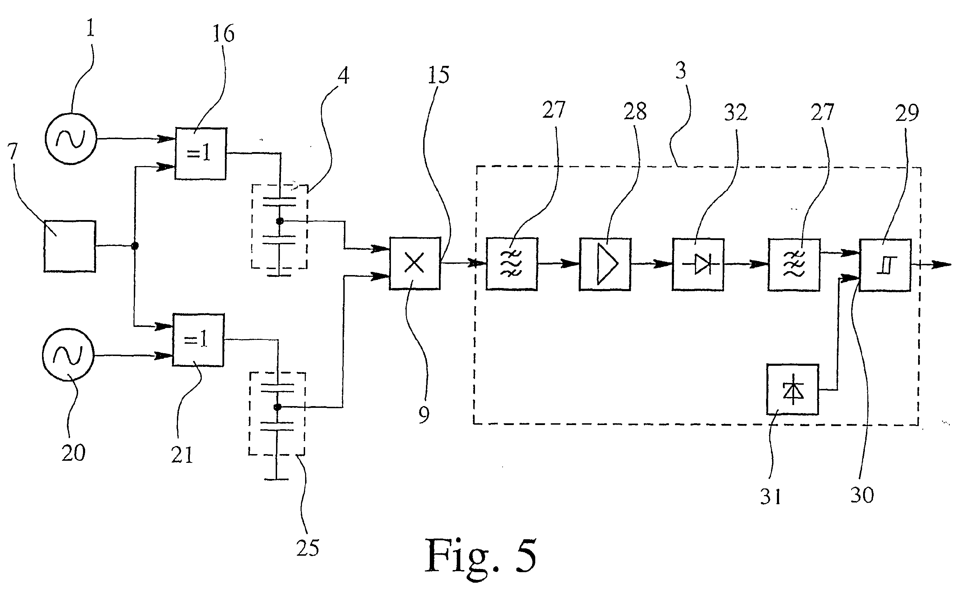

Im Unterschied zur Schaltungsanordnung gemäß Fig. 4 enthält die Schaltungsanordnung gemäß Fig. 5 einen zweiten Oszillator 20 und einen zweiten Inverter 21. Die Schaltungsanordnung gemäß Fig. 5 entspricht im wesentlichen der Schaltungsanordnung gemäß Fig. 2a. Das von dem Oszillator 1 gelieferte Meßsignal und das von dem Oszillator 20 gelieferte Hilfssignal führen am Ausgang 15 des zweiten Korrelators 9, welcher beispielsweise als Ringmischer ausführt sein kann, zu einem Wechselspannungssignal, dessen Frequenz der Frequenzdifferenz von Meßsignal zu Hilfssignal entspricht. Dieses als Zwischenfrequenz bezeichnete Signal wird zunächst von einem Filter 27 gefiltert und anschließend auf einen Verstärker 28 gegeben.

Die Frequenz des Meßsignals und des Hilfssignals liegt vorteilhafterweise im Frequenzbereich von 1 bis 10 MHz, da bei niedrigeren Frequenzen die Empfindlichkeit des Sensors zu gering ist. Die Frequenzdifferenz zwischen dem Meßsignal und dem Hilfssignal wird relativ gering gewählt. Vorteilhafterweise beträgt die Frequenzdifferenz einige hundert kHz oder weniger. Der Vorteil einer niedrigen bis mittleren Zwischenfrequenz ist es, daß einfache und damit preiswerte Filter verwendet werden können, die keinen Abgleich brauchen. Es können beispielsweise Aktivfilter oder Keramikfilter verwendet werden.

Zu der Auswerteschaltung 3 in der Schaltungsanordnung gemäß Fig. 5 gehört neben dem ersten Filter 27 und dem Verstärker 28 noch ein zweites Filter 27 und ein Gleichrichter 32. Der Gleichrichter 32 ist hinter den Verstärker 28 und vor das zweite Filter 27 geschaltet, dem sich, wie bei der Schaltungsanordnung gemäß Fig. 4, ein Spannungskomparator 29 mit Hysterese anschließt.

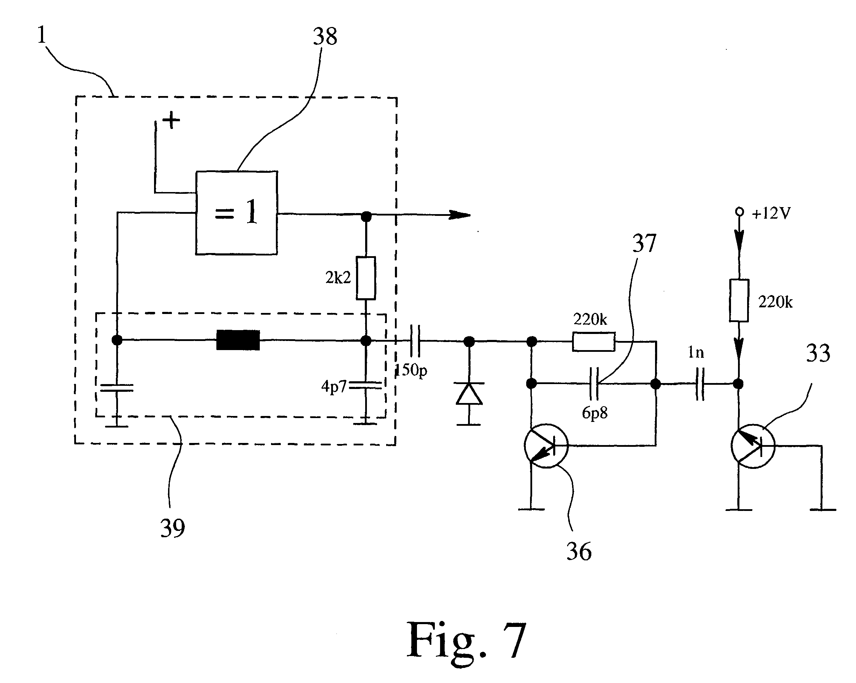

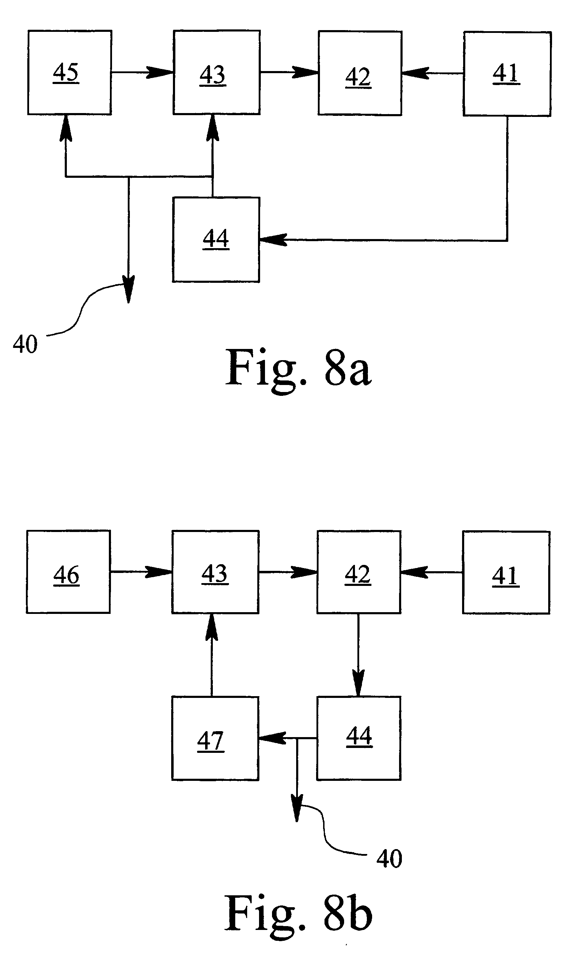

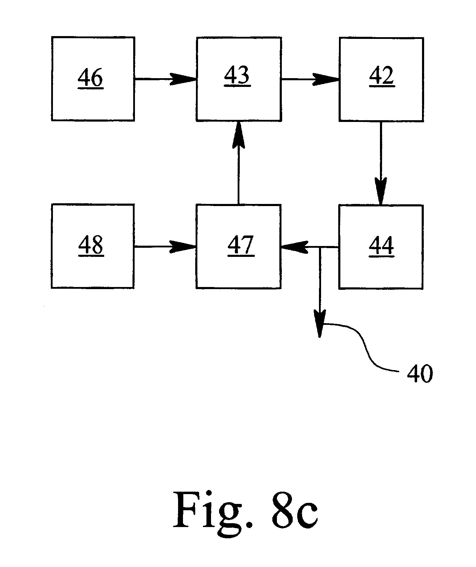

Abschließend zeigen die Fig. 6a, 6b, 7, 8a, 8b und 8c konkrete Ausführungsbeispiele der erfindungsgemäßen Schaltungsanordnung, wobei jedoch nicht die gesamte zu dem Schalter gehörende Schaltungsanordnug dargestellt ist. Nicht dargestellt ist in den Fig. 6a, 6b und 7 die Auswerteschaltung 3, da eine erfmdungsgemäße Schaltungsanordnung zwar eine Auswerteschaltung 3 enthält, das Erfindungswesentliche jedoch nicht die Auswerteschaltung 3 betrifft. In den Fig. 8a, 8b und 8c sind nur Ausführungsbeispiele für Eingangsteile der erfindungsgemäßen Schaltungsanordnung dargestellt.

Die Schaltungsanordnung gemäß der Fig. 6a besteht aus einem ersten Oszillator 1 mit einer Frequenz von 6 MHz und einem zweiten Oszillator 20 mit einer Frequenz von 5,9 MHz. Darüber hinaus weist die Schaltungsanordnung einen Sensor 4, einen ersten Inverter 16 und einen zweiten Inverter 21 sowie einen Korrelator 9 auf. Als Rauschquelle wird die Emitterdiode eines Transistors 33 im Durchbruchbetrieb genutzt. Der Vorteil einer Emitterdiode als Rauschquelle liegt in dem sehr geringen Stromverbrauch von ca. 14 µA und den geringen Kosten für einen normalen Transistor. Für den Durchbruchbetrieb des Transistors 33 ist eine Spannung von ca. 9 V erforderlich, welche durch Anlegen des Transistors 33 an die Betriebsspannung von 12 V sichergestellt ist. Parallel zur Basis-Emitter-Strecker des Transistors 33 liegt ein Kondensator, durch den zu hochfrequente Rauschsignalanteile kurzgeschlossen werden.

Das von dem Transistor 33 gelieferte Rauschsignal wird einem Analogverstärker 34 zugeführt, dem sich ein Schmitt-Trigger 35 anschließt. Durch den Schmitt-Trigger 35 ist sichergestellt, daß an den Eingängen 18 bzw. 23 der beiden Inverter 16 bzw. 21 keine Zwischenwerte anliegen, sondern nur ein von der Rauschquelle abgeleitetes binäres Zufallssignal. Auf die beiden anderen Eingänge 17 bzw. 22 der Inverter 16 bzw. 21 wird das Meßsignal des Oszillators 1 bzw. das Hilfssignal des Oszillators 20 gegeben.

Der Ausgang 19 des Inverters 16 ist mit der Sendeelektrode 5 des Sensors 4 über einen Widerstand verbunden. Die Meßelektrode 6 ist über ein RC-Glied mit dem zweiten Eingang 14 des Korrelators 9 verbunden. Der Ausgang 24 des zweiten Inverters 21 ist über ein aus zwei Kondensatoren und einen Widerstand bestehendes Anpassungsnetzwerk 25 mit dem ersten Eingang 13 des Korrelators 9 verbunden. Am Ausgang 15 des Korrelators 9 liegt somit ein Wechselspannungssignal mit einer Zwischenfrequenz von 100 kHz an.

Als Inverter 16 und 21 werden vorteilhafterweise EX-OR-Gatter verwendet, wobei insbesondere HCMOS-Mehrfach-Gatter-IC's besonders geeignet sind, da diese Gatter auch als Oszillatorbauelemente verwendet werden können, so daß beide Inverter 16, 21 und beide Oszillatoren 1,20 auf einem IC 74 HC 86 mit vier Gattern untergebracht werden können.

Die Schaltungsanordnung gemäß der Fig. 6b entspricht im wesentlichen der Schaltungsanordnung gemäß der Fig. 6a. Sie unterscheidet sich von der Schaltungsanordnung gemäß Fig. 6a einerseits hinsichtlich der Realisierung der Rauschquelle, andererseits hinsichtlich der Ausbildung der den Ausgängen 19 bzw. 24 der Inverter 16 bzw. 21 folgenden Übertragungswege.

Im Ausführungsbeispiel nach Fig. 6b arbeitet die Rauschquelle auf einen LC-Schwingkreis, den die Rauschquelle zum Schwingen anregt. Dadurch ist in bezug auf das Rauschsignal eine definierte Bandbreite und eine definierte Mittenfrequenz realisiert.

Für das Ausführungsbeispiel nach Fig. 6b gilt weiter, daß die den Ausgängen 19 bzw. 24 der Inverter 16 bzw. 21 folgenden Übertragungswege einander entsprechen. Der Ausgang 19 des Inverters 16 ist über einen Widerstand mit der Sendeelektrode 5 des Sensors 4 verbunden. Die Meßelektrode 6 ist über ein RC-Glied mit dem zweiten Eingang 14 des Korrelators 9 verbunden. Der Ausgang 24 des zweiten Inverters 21 ist über ein aus zwei Kondensatoren und aus einem Widerstand bestehendes Anpassungsnetzwerk 25 mit dem ersten Eingang 13 des Korrelators 9 verbunden. Zu dem dem Ausgang 19 des Inverters 16 folgenden Übertragungsweg gehören noch diskret nicht verwirklichte, gleichwohl aber vorhandene Kapazitäten, und zwar einerseits zwischen der Sendeelektrode 5 und der Meßelektrode 6 und andererseits zwischen der Meßelektrode 6 und Masse. Entspricht das Verhältnis der Kapazitäten der beiden zu dem Anpassungsnetzwerk 25 gehörenden Kondensatoren dem Verhältnis der beiden zuvor angesprochenen, in Verbindung mit der Sendeelektrode 5 und der Meßelektrode 6 wirksamen Kapazitäten, so gilt das, was zuvor angesprochen worden ist, daß sich nämlich die Übertragungswege, die dem Ausgang 19 des Inverters 16 einerseits und dem Ausgang 24 des Inverters 21 andererseits folgen, entsprechen.

In Fig. 7 ist eine Schaltungsanordnung dargestellt, bei der die Frequenzspreizung des Meßsignals nicht, wie in den Fig. 2 bis 6 dargestellt, durch eine Phasenumtastung des Meßsignals in einem Inverter realisiert wird, sondern durch eine Frequenzmodulation des Meßsignals mit dem Rauschsignal. Auch hier dient als Rauschquelle die Emitterdiode eines Transistors 33 im Durchbruchbetrieb. Als Rauschverstärker, wie eine Varicapdiode arbeitend, dient ein zweiter Transistor 36. Die Funktion des Transistors 36 entspricht der einer Reaktanzröhre, bei der die Miller-Kapazität 37 mit der steuerbaren Verstärkung des Transistors 36 multipliziert wird. Der Transistor 33 und der Transistor 36 sind über einen Hochpaßfilter miteinander verbunden. Als Oszillator 1 wird ein Inverter 38, der vorzugsweise als Analog-Multiplexer ausgeführt ist, und ein LC-π-Filter 39 verwendet. Ein solcher Oszillator hat den Vorteil, daß er sehr gut modulierbar ist, im Gegensatz beispielsweise zu einem Quarzoszillator. Das so frequenzmodulierte Meßsignal wird über einen Gleichrichter auf die Sendeelektrode des Sensors gegeben.

Die zuvor beschriebene Schaltungsanordnung benötigt nur sehr wenige Bauteile, insbesondere keinen zweiten Oszillator, ist somit kostengünstig herzustellen und hat durch die Verwendung der Emitterdiode des Transistors 33 als Rauschquelle auch nur einen sehr geringen Stromverbrauch. Die geringe Rauschleistung der Emitterdiode bewirkt zwar nur einen geringen Frequenzhub der Grundwelle bei der Frequenzmodulation, da jedoch die Oberwellenfrequenzen des Meßsignals bezüglich der Störabstrahlung wesentlich kritischer sind und der Frequenzhub sich mit der Ordnungszahl der Oberwellen multiplizert, ist der Frequenzhub bei den kritischen Oberwellen ausreichend groß. Eine solche Schaltungsanordnung eignet sich besonders für dynamisch arbeitende 2-Leiter-Näherungsschalter.

Zur Erläuterung dessen, was in den Fig. 8a, 8b, und 8c dargestellt ist, soll angeschlossen werden an das in Fig. 4 dargestellte Ausführungsbeispiel einer erfindungsgemäßen Schaltungsanordnung. Dabei ist dann der jeweilige Ausgang 40 der in den Fig. 8a, 8b und 8c dargestellten Teile einer erfindungsgemäßen Schaltungsanordnung vergleichbar mit dem Ausgang 19 des Inverters 16 bei der Schaltungsanordnung gemäß Fig. 4. Der Ausgang 40 der in den Fig. 8a, 8b und 8c dargestellten Teile einer erfindungsgemäßen Schaltungsanordnung ist also, wie für den Ausgang 19 des Inverters 16 in Fig. 4 dargestellt, über entsprechende Übertragungswege - in Fig. 4 als Anpassungsnetzwerk 25 und als Sensor 4 dargestellt - mit den Eingängen 13 und 14 des zweiten Korrelators 9 zu verbinden.

Bei den Ausführungsbeispielen nach den Fig. 8a und 8b sind jeweils eine Modulationsquelle 41, ein Tiefpaß 42, ein Phasenkomparator 43 und ein spannungsgesteuerter Oszillator 44, ein sogenannter VCO (VCO = Voltage Controlled Oscillator), vorgesehen. Im Ausführungsbeispiel nach Fig. 8a ist noch ein frequenzabhängiger Phasenschieber 45 vorgesehen, während bei dem Ausführungsbeispiel nach Fig. 8b noch eine niederfrequente Referenzspannungsquelle 46 und ein programmierbarer Frequenzteiler 47 vorgesehen sind.

Für das Ausführungsbeispiel nach Fig. 8c gilt, daß auch hier ein Tiefpaß 42, ein Phasenkomparator 43, ein spannungsgesteuerter Oszillator 44, eine niederfrequente Referenzspannungsquelle 46 und ein programmierbarer Frequenzteiler 47 vorgesehen sind. Darüber hinaus gehört zu dem Ausführungsbeispiel nach Fig. 8c noch ein Mikroprozessor 48. Der programmierbare Frequenzteiler 47 führt in Verbindung mit dem Mikroprozessor 48, der eine Zufallsfolge abgibt, zu der gewünschten Rauschmodulation.

Für die Ausführungsbeispiele nach den Fig. 8a, 8b und 8c gilt, daß die Frequenzmodulation des Meßsignals mit Hilfe einer Nachlaufsynchronisation (Phase-Locked-Loop, PLL) als Taktgenerator erfolgt.

Die Erfindung ist zuvor ausschließlich in Verbindung mit kapazitiven Schaltern beschrieben worden. Sie ist jedoch ohne weiteres auch auf andere elektronische Geräte anwendbar, die einerseits elektromagnetische Strahlen und Signale in die Umwelt abgeben und andererseits empfindlich sind gegen die Aufnahme elektromagnetischer Strahlen und Signale aus der Umwelt. Solche elektronischen Geräte sind beispielsweise, aber nicht ausschließlich, auch induktive und optoelektronische Schalter.

## Patentansprüche

1. Verfahren zum Betreiben eines kapazitiven Schalters, wobei der Schalter einen ein Meßsignal liefernden Oszillator, einen aus zumindest einer Sendeelektrode und einer Meßelektrode bestehenden kapazitiven Sensor und eine Auswerteschaltung aufweist, **dadurch gekennzeichnet, daß** das Meßsignal durch ein von einer Rauschquelle geliefertes Rauschsignal frequenzgespreizt wird, daß das frequenzgespreizte Meßsignal einerseits - vorzugsweise über ein Anpassungsnetzwerk - auf den ersten Eingang eines Korrelators gegeben und andererseits von der Sendeelektrode des kapazitiven Sensors abgestrahlt wird, daß das von der Meßelektrode des Sensors aufgenommene Empfangssignal auf den zweiten Eingang des Korrelators gegeben wird und daß das Ausgangssignal des Korrelators der Auswerteschaltung zugeführt wird.

2. Verfahren zum Betreiben eines kapazitiven Schalters, wobei der Schalter einen ein Meßsignal liefernden Oszillator, einen aus zumindest einer Sendeelektrode und einer Meßelektrode bestehenden kapazitiven Sensor und eine Auswerteschaltung aufweist, **dadurch gekennzeichnet, daß** ein zweiter Oszillator ein Hilfssignal erzeugt, welches die gleiche oder eine geringfügig andere Frequenz als das Meßsignal hat, daß das Meßsignal und das Hilfssignal durch ein von einer Rauschquelle geliefertes Rauschsignal frequenzgespreizt werden, daß das frequenzgespreizte Meßsignal von der Sendeelektrode des kapazitiven Sensors abgestrahlt wird, daß das frequenzgespreizte Hilfssignal - vorzugsweise über ein Anpassungsnetzwerk - auf den ersten Eingang eines Korrelators gegeben wird, daß das von der Meßelektrode des Sensors aufgenommene Empfangssignal auf den zweiten Eingang des Korrelators gegeben wird und daß das Ausgangssignal des Korrelators der Auswerteschaltung zugeführt wird.

3. Verfahren nach Anspruch 1 oder 2, **dadurch gekennzeichnet, daß** die Frequenzspreizung des Meßsignals bzw. des Hilfssignals durch eine Frequenzmodulation des Meßsignals bzw. des Hilfssignals mit dem Rauschsignal erzeugt wird.

4. Verfahren nach Anspruch 3, **dadurch gekennzeichnet, daß** die Frequenzmodulation des Meßsignals bzw. des Hilfssignals durch einen Transistor, der gleichzeitig als Rauschverstärker dient, oder mit Hilfe einer Nachlaufsynchronisation (Phase-Locked-Loop, PLL) als Taktgenerator erfolgt.

5. Verfahren nach Anspruch 1 oder 2, **dadurch gekennzeichnet, daß** die Frequenzspreizung des Meßsignals bzw. des Hilfssignals durch eine Phasenumtastung des Meßsignals bzw. des Hilfssignals erzeugt wird.

6. Verfahren nach Anspruch 5, **dadurch gekennzeichnet, daß** die Frequenzspreizung des Meßsignals bzw. des Hilfssignals mit Hilfe eines aus dem Rauschsignal erhaltenen binären Zufallssignals durch eine 0/180°-Phasenumtastung erfolgt.

7. Verfahren nach Anspruch 6, **dadurch gekennzeichnet, daß** die Phasenumtastung mittels eines Inverters, insbesondere eines EX-OR-Gatters oder eines Ringmischers, erfolgt.

8. Verfahren nach einem der Ansprüche 1 bis 7, **dadurch gekennzeichnet, daß** als Rauschquelle die Emitterdiode eines Transistors im Durchbruchbetrieb verwendet wird.

9. Verfahren nach einem der Ansprüche 1 bis 7, **dadurch gekennzeichnet, daß** als Rauschquelle eine digitale Rauschquelle mit einer Pseudozufallsfolge mit endlicher Periodenlänge verwendet wird.

10. Schaltungsanordnung eines kapazitiven Schalters, mit einen Oszillator (1), mit einer Meßstrecke (2) und mit einer Auswerteschaltung (3), wobei der Oszillator (1) ein Meßsignal liefert und die Meßstrecke (2) zumindest einen Sensor (4) mit einer Sendeelektrode (5) und einer Meßelektrode (6) aufweist, **dadurch gekennzeichnet, daß** eine Rauschquelle (7) und zwei Korrelatoren (8, 9) vorhanden sind, daß in dem ersten Korrelator (8) eine Frequenzspreizung des Meßsignals durch die Rauschquelle (7) erfolgt, daß das frequenzgespreizte Meßsignal einerseits mit dem ersten Eingang (13) des zweiten Korrelators (9) und andererseits mit der Sendeelektrode (5) verbunden ist und daß die Meßelektrode (6) mit dem zweiten Eingang (14) des zweiten Korrelators (9) verbunden ist.

11. Schaltungsanordnung nach Anspruch 10, **dadurch gekennzeichnet, daß** die Rauschquelle (7) aus der Emitterdiode eines Transistors (33) im Durchbruchbetrieb besteht.

12. Schaltungsanordnung nach Anspruch 10 oder 11, **dadurch gekennzeichnet, daß** als erster Korrelator (8) ein Transistor (34) vorgesehen ist, der einerseits als Rauschverstärker dient, andererseits das Meßsignals mit dem Rauschsignal frequenzmoduliert.

13. Schaltungsanordnung nach einem der Ansprüche 10 bis 12, **dadurch gekennzeichnet, daß** der erste Korrelator als Inverter (16) ausgebildet ist, daß der erste Eingang (17) des Inverters (16) mit dem Meßsignal und der zweite Eingang (18) des Inverters (16) mit der Rauschquelle (7) verbunden ist und daß der Ausgang (19) des Inverters (16) einerseits mit dem ersten Eingang (13) des zweiten Korrelators (9) und andererseits mit der Sendeelektrode (5) verbunden ist.

14. Schaltungsanordnung nach Anspruch 13, **dadurch gekennzeichnet, daß** ein zweiter, ein Hilfssignal erzeugender Oszillator (20) und ein zweiter Inverter (21) vorhanden sind, daß der erste Eingang (22) des zweiten Inverters (21) mit dem Hilfssignal und der zweite Eingang (23) des zweiten Inverters (21) mit der Rauschquelle (7) verbunden ist und daß der Ausgang (19) des ersten Inverters (16) mit der Sendeelektrode (5) und der Ausgang (24) des zweiten Inverters (21) mit dem ersten Eingang (13) des zweiten Korrelators (9) verbunden ist.

15. Schaltungsanordnung nach Anspruch 14, **dadurch gekennzeichnet, daß** zwischen dem Ausgang (24) des zweiten Inverters (21) und dem ersten Eingang (13) des zweiten Korrelators (9) ein Anpassungsnetzwerk (25) geschaltet ist.

16. Schaltungsanordnung nach einem der Ansprüche 13 bis 15, **dadurch gekennzeichnet, daß** als Inverter (16,21) ein EX-OR-Gatter vorgesehen ist.

17. Schaltungsanordnung nach einem der Ansprüche 14 bis 16, **dadurch gekennzeichnet, daß** sowohl die Oszillatoren (1, 20) als auch die Inverter (16, 21) in einem IC intergriert sind.

18. Schaltungsanordnung nach einem der Ansprüche 10 bis 17, **dadurch gekennzeichnet, daß** zu der Auswerteschaltung (3) ein Filter (27), ein Verstärker (28) und ein Spannungskomparator (29) gehören.

19. Schaltungsanordnung nach einem der Ansprüche 10 bis 18, **dadurch gekennzeichnet, daß** als Oszillator (1, 20) ein LC-Oszillator vorgesehen ist.

20. Schaltungsanordnung nach einem der Ansprüche 10 bis 19, **dadurch gekennzeichnet, daß** als Korrelator (8, 9) ein Multiplikations-, ein Relais- oder ein Polaritätskorrelator vorgesehen ist.

## Claims

1. Method for operating a capacitive switch, where the switch has an oscillator delivering a measurement signal, a capacitive sensor comprising at least one transmission electrode and a measurement electrode, and an evaluation circuit, **characterized in that** the measurement signal is frequency-spread by a noise signal delivered by a noise source, **in that** the frequency-spread measurement signal is firstly passed to the first input of a correlator - preferably via a matching network - and is secondly emitted by the transmission electrode of the capacitive sensor, **in that** the received signal picked up by the measurement electrode of the sensor is passed to the second input of the correlator, and **in that** the output signal from the correlator is supplied to the evaluation circuit.

2. Method for operating a capacitive switch, where the switch has an oscillator delivering a measurement signal, a capacitive sensor comprising at least one transmission electrode and a measurement electrode, and an evaluation circuit, **characterized in that** a second oscillator produces an auxiliary signal which has the same or a slightly different frequency as/from the measurement signal, **in that** the measurement signal and the auxiliary signal are frequency-spread by a noise signal delivered by a noise source, **in that** the frequency-spread measurement signal is emitted by the transmission electrode of the capacitive sensor, **in that** the frequency-spread auxiliary signal is passed to the first input of a correlator - preferably via a matching network, **in that** the received signal picked up by the measurement electrode of the sensor is passed to the second input of the correlator, and **in that** the output signal from the correlator is supplied to the evaluation circuit.

3. Method according to Claim 1 or 2, **characterized in that** the frequency spreading for the measurement signal and for the auxiliary signal is produced by means of frequency modulation of the measurement signal and of the auxiliary signal with the noise signal.

4. Method according to Claim 3, **characterized in that** the frequency modulation for the measurement signal and for the auxiliary signal is performed by a transistor, which simultaneously serves as a noise amplifier, or using a phase locked loop (PLL) as a clock generator.

5. Method according to Claim 1 or 2, **characterized in that** the frequency spreading for the measurement signal and for the auxiliary signal is produced by means of phase shift keying for the measurement signal or for the auxiliary signal.

6. Method according to Claim 5, **characterized in that** the frequency spreading for the measurement signal and for the auxiliary signal is performed by means of 0/180° phase shift keying using a binary random signal obtained from the noise signal.

7. Method according to Claim 6, **characterized in that** the phase shift keying is performed using an inverter, particularly an EX-OR gate or a ring mixer.

8. Method according to one of Claims 1 to 7, **characterized in that** the noise source used is the emitter diode of a transistor in breakdown mode.

9. Method according to one of Claims 1 to 7, **characterized in that** the noise source used is a digital noise source with a pseudo-random sequence of finite period length.

10. Circuit arrangement for a capacitive switch, having an oscillator (1), having a measurement path (2) and having an evaluation circuit (3), where the oscillator (1) delivers a measurement signal and the measurement path (2) has at least one sensor (4) with a transmission electrode (5) and a measurement electrode (6), **characterized in that** a noise source (7) and two correlators (8, 9) are provided, **in that** the measurement signal is frequency-spread in the first correlator (8) by the noise source (7), **in that** the frequency-spread measurement signal is connected firstly to the first input (13) of the second correlator (9) and secondly to the transmission electrode (5), and **in that** the measurement electrode (6) is connected to the second input (14) of the second correlator (9).

11. Circuit arrangement according to Claim 10, **characterized in that** the noise source (7) comprises an emitter diode of a transistor (33) in breakdown mode.

12. Circuit arrangement according to Claim 10 or 11, **characterized in that** the first correlator (8) provided is a transistor (34), which is firstly used as a noise amplifier and secondly frequency-modulates the measurement signal with the noise signal.

13. Circuit arrangement according to one of Claims 10 to 12, **characterized in that** the first correlator is in the form of an inverter (16), **in that** the first input (17) of the inverter (16) is connected to the measurement signal, and the second input (18) of the inverter (16) is connected to the noise source (7), and **in that** the output (19) of the inverter (16) is connected firstly to the first input (13) of the second correlator (9) and secondly to the transmission electrode (5).

14. Circuit arrangement according to Claim 13, **characterized in that** a second oscillator (20), producing an auxiliary signal, and a second inverter (21) are provided, **in that** the first input (22) of the second inverter (21) is connected to the auxiliary signal, and the second input (23) of the second inverter (21) is connected to the noise source (7), and **in that** the output (19) of the first inverter (16) is connected to the transmission electrode (5), and the output (24) of the second inverter (21) is connected to the first input (13) of the second correlator (9).

15. Circuit arrangement according to Claim 14, **characterized in that** a matching network (25) is connected between the output (24) of the second inverter (21) and the first input (13) of the second correlator (9).

16. Circuit arrangement according to one of Claims 13 to 15, **characterized in that** the inverter (1-6, 21) provided is an EX-OR gate.

17. Circuit arrangement according to one of Claims 14 to 16, **characterized in that** both the oscillators (1, 20) and the inverters (16, 21) are integrated in an IC.

18. Circuit arrangement according to one of Claims 10 to 17, **characterized in that** the evaluation circuit (3) includes a filter (27), an amplifier (28) and a voltage comparator (29).

19. Circuit arrangement according to one of 10 to 18, **characterized in that** the oscillator (1, 20) provided is an LC oscillator.

20. Circuit arrangement according to one of Claims 10 to 19, **characterized in that** the correlator (8, 9) provided is a multiplication correlator, a relay correlator or a polarity correlator.

## Revendications

1. Procédé de fonctionnement d'un commutateur capacitif, dans lequel le commutateur comporte un oscillateur fournissant un signal de mesure, un détecteur capacitif composé d'au moins une électrode d'émission et d'une électrode de mesure et un circuit d'évaluation, **caractérisé en ce que** le signal de mesure est étalé en fréquence par un signal de bruit produit par une source de bruit, **en ce que** le signal de mesure étalé en fréquence est d'une part appliqué à la première entrée d'un corrélateur - de préférence via un circuit d'adaptation - et est d'autre part émis par l'électrode d'émission du détecteur capacitif, **en ce que** le signal de réception capté par l'électrode de mesure du détecteur est appliqué à la deuxième entrée du corrélateur et **en ce que** le signal de sortie du corrélateur est envoyé au circuit d'évaluation.

2. Procédé de fonctionnement d'un commutateur capacitif, dans lequel le commutateur comporte un oscillateur fournissant un signal de mesure, un détecteur capacitif composé d'au moins une électrode d'émission et d'une électrode de mesure et un circuit d'évaluation, **caractérisé en ce qu'**un deuxième oscillateur produit un signal auxiliaire, qui présente une fréquence égale ou légèrement différente de celle du signal de mesure, **en ce que** le signal de mesure et le signal auxiliaire sont étalés en fréquence par un signal de bruit produit par une source de bruit, **en ce que** le signal de mesure étalé en fréquence est émis par l'électrode d'émission du détecteur capacitif, **en ce que** le signal auxiliaire étalé en fréquence est appliqué à la première entrée d'un corrélateur - de préférence via un circuit d'adaptation, **en ce que** le signal de réception capté par l'électrode de mesure du détecteur est appliqué à la deuxième entrée du corrélateur et **en ce que** le signal de sortie du corrélateur est envoyé au circuit d'évaluation.

3. Procédé selon la revendication 1 ou 2, **caractérisé en ce que** l'étalement de fréquence du signal de mesure respectivement du signal auxiliaire est produit par une modulation de fréquence du signal de mesure respectivement du signal auxiliaire avec le signal de bruit.

4. Procédé selon la revendication 3, **caractérisé en ce que** la modulation de fréquence du signal de mesure respectivement du signal auxiliaire est effectuée par un transistor, qui sert en même temps d'amplificateur de bruit, ou à l'aide d'une synchronisation de poursuite (boucle à blocage de phase, PLL) comme générateur d'horloge.

5. Procédé selon la revendication 1 ou 2, **caractérisé en ce que** l'étalement de fréquence du signal de mesure respectivement du signal auxiliaire est produit par une manipulation de phase du signal de mesure respectivement du signal auxiliaire.

6. Procédé selon la revendication 5, **caractérisé en ce que** l'étalement de fréquence du signal de mesure respectivement du signal auxiliaire est effectué par une manipulation de phase 0/180° à l'aide d'un signal aléatoire binaire obtenu à partir du signal de bruit.

7. Procédé selon la revendication 6, **caractérisé en ce que** la manipulation de phase est effectuée au moyen d'un inverseur, en particulier d'une grille EX-OR ou d'un mélangeur en anneau.

8. Procédé selon l'une quelconque des revendications 1 à 7, **caractérisé en ce que** l'on utilise comme source de bruit une diode émettrice d'un transistor en état de claquage.

9. Procédé selon l'une quelconque des revendications 1 à 7, **caractérisé en ce que** l'on utilise comme source de bruit une source de bruit numérique avec une séquence pseudo-aléatoire avec une longueur de période finie.

10. Circuit d'un commutateur capacitif, avec un oscillateur (1), avec une zone de mesure (2) et avec un circuit d'évaluation (3), dans lequel l'oscillateur (1) produit un signal de mesure et la zone de mesure (2) comprend au moins un détecteur (4) avec une électrode d'émission (5) et une électrode de mesure (6), **caractérisé en ce qu'**il comprend une source de bruit (7) et deux corrélateurs (8, 9), **en ce qu'**il se produit dans le premier corrélateur (8) un étalement de fréquence du signal de mesure par la source de bruit (7), **en ce que** le signal de mesure étalé en fréquence est relié d'une part à la première entrée (13) du deuxième corrélateur (9) et d'autre part à l'électrode d'émission (5) et **en ce que** l'électrode de mesure (6) est reliée à la deuxième entrée (14) du deuxième corrélateur (9).

11. Circuit selon la revendication 10, **caractérisé en ce que** la source de bruit (7) se compose de la diode émettrice d'un transistor (33) en état de claquage.

12. Circuit selon la revendication 10 ou 11, **caractérisé en ce qu'**il est prévu comme premier corrélateur (8) un transistor (34), qui sert d'une part d'amplificateur de bruit et qui effectue d'autre part la modulation de fréquence du signal de mesure avec le signal de bruit.

13. Circuit selon l'une quelconque des revendications 10 à 12, **caractérisé en ce que** le premier corrélateur est formé par un inverseur (16), **en ce que** la première entrée (17) de l'inverseur (16) est reliée au signal de mesure et la deuxième entrée (18) de l'inverseur (16) est reliée à la source de bruit (7), et **en ce que** la sortie (19) de l'inverseur (16) est reliée d'une part à la première entrée (13) du deuxième corrélateur (9) et d'autre part à l'électrode d'émission (5).

14. Circuit selon la revendication 13, **caractérisé en ce qu'**il comprend un deuxième oscillateur (20) produisant un signal auxiliaire et un deuxième inverseur (21), **en ce que** la première entrée (22) du deuxième inverseur (21) est reliée au signal auxiliaire et la deuxième entrée (23) du deuxième inverseur (21) est reliée à la source de bruit (7), et **en ce que** la sortie (19) du premier inverseur (16) est reliée à l'électrode d'émission (5) et la sortie (24) du deuxième inverseur (21) est reliée à la première entrée (13) du deuxième corrélateur (9).

15. Circuit selon la revendication 14, **caractérisé en ce qu'**un circuit d'adaptation (25) est monté entre la sortie (24) du deuxième inverseur (2.1) et la première entrée (13) du deuxième corrélateur (9).

16. Circuit selon l'une quelconque des revendications 13 à 15, **caractérisé en ce qu'**il est prévu comme inverseur (16, 21) une grille EX-OR.

17. Circuit selon l'une quelconque des revendications 14 à 16, **caractérisé en ce qu'**aussi bien les oscillateurs (1, 20) que les inverseurs (16, 21) sont intégrés dans un circuit intégré (IC).

18. Circuit selon l'une quelconque des revendications 10 à 17, **caractérisé en ce qu'**un filtre (27), un amplificateur (28) et un comparateur de tension (29) font partie du circuit d'évaluation (3).

19. Circuit selon l'une quelconque des revendications 10 à 18, **caractérisé en ce qu'**il est prévu comme oscillateur (1, 20) un oscillateur LC.

20. Circuit selon l'une quelconque des revendications 10 à 19, **caractérisé en ce qu'**il est prévu comme corrélateur (8, 9) un corrélateur à multiplication, à relais ou à polarité.
